(19) **Europäisches Patentamt / European Patent Office / Office européen des brevets**

(11) **EP 2 118 026 B1**

(12) **EUROPEAN PATENT SPECIFICATION**

(45) Date of publication and mention
of the grant of the patent:
**03.04.2013 Bulletin 2013/14**

(21) Application number: **08716965.2**

(22) Date of filing: **20.02.2008**

(51) Int Cl.:
*C03B 19/14* (2006.01)      *C03C 3/06* (2006.01)
*G03F 7/20* (2006.01)

(86) International application number:
**PCT/EP2008/052045**

(87) International publication number:
**WO 2008/104485 (04.09.2008 Gazette 2008/36)**

(54) **OPTICAL COMPONENT MADE FROM SYNTHETIC QUARTZ GLASS WITH ENHANCED RADIATION RESISTANCE, AND METHOD FOR PRODUCING THE COMPONENT**

OPTISCHES BAUTEIL AUS SYNTHETISCHEM QUARZGLAS MIT ERHÖHTER STRAHLUNGSBESTÄNDIGKEIT UND VERFAHREN ZUR HERSTELLUNG DES BAUTEILS

COMPOSANT OPTIQUE FABRIQUÉ À PARTIR DE VERRE DE SILICE SYNTHÉTIQUE AVEC UNE RÉSISTANCE AU RAYONNEMENT RENFORCÉE ET PROCÉDÉ DE PRODUCTION DE CE COMPOSANT

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.02.2007 DE 102007009802**
**11.04.2007 DE 102007017004**

(43) Date of publication of application:
**18.11.2009 Bulletin 2009/47**

(73) Proprietor: **Heraeus Quarzglas GmbH & Co. KG**
**63450 Hanau (DE)**

(72) Inventors:
• **KUEHN, Bodo**
  **63571 Gelnhausen (DE)**

• **OCHS, Stefan**
  **65520 Bad Camberg (DE)**
• **WEBER, Juergen**
  **63801 Kleinostheim (DE)**

(74) Representative: **Staudt, Armin Walter**
**Patentanwalt**
**Sandeldamm 24a**
**63450 Hanau (DE)**

(56) References cited:
JP-A- 2000 143 257     JP-A- 2000 169 155
JP-A- 2000 185 924     US-A1- 2006 234 848

## Description

The present invention relates to an optical component made from synthetic quartz glass with enhanced radiation resistance to irradiation with excimer laser, for use in immersion lithography at an operating wavelength below 250 nm.

Furthermore, the present invention relates to a method for producing synthetic quartz glass with a predetermined hydroxyl group content, the method comprising the following steps:

(a) a porous $SiO_2$ soot body is produced by flame hydrolysis or oxidation of a silicon-containing start compound and by layerwise deposition of $SiO_2$ particles on a carrier,
(b) the soot body is subjected to a dehydration treatment in a drying atmosphere for removing hydroxyl groups, so that a mean hydroxyl group content of less than 60 wt ppm is set,
(c) the $SiO_2$ soot body is vitrified to obtain a body made from the synthetic quartz glass, and
(d) the mean hydrogen content of the quartz glass is set to a value of less than $2x10^{17}$ molecules/$cm^3$.

Optical components of quartz glass are used for the transmission of high-energy ultraviolet excimer laser radiation in microlithographic exposure and projection systems for making large-scale integrated circuits on substrates.

Technical Background

Immersion lithography gains more and more importance. The gap between the substrate to be exposed in the image plane and the last optical component of the lens system is here filled with a liquid having a higher refractive index than air. The higher refractive index of the liquid in comparison with air creates a larger numerical aperture of the projection objective on the whole, thereby improving the resolution of the system.

The high-energy laser radiation induces defects in the glass structure that deteriorate the imaging properties of the component. Particular mention should here be made of the so-called "compaction" of the quartz glass. This compaction manifests itself in a local increase in density of the glass in the volume penetrated by radiation, which leads to a locally inhomogeneous rise in the refractive index and thus to a deterioration of the imaging properties of the optical component.

The demands made on the optical properties of the components for such exposure and projection systems and on their radiation resistance are getting higher and higher. Especially the requirements regarding the radiation-induced wavefront distortion are getting stricter and stricter.

Likewise, solutions proposed for example in EP 1 712 528 A2 and EP 1 586 544 A1, which come down to a low defect concentration of the glass structure due to a low concentration of SiH, halogen or hydroxyl groups or to a suitable annealing of the quartz glass, turn out to be inadequate by now.

The present invention starts from an $SiO_2$ soot body. This is a hollow cylinder or a solid cylinder consisting of porous $SiO_2$ soot which is obtained according to the known VAD (vapor axial deposition) method or the OVD (outside vapor deposition) method. As a rule, soot bodies contain a high content of hydroxyl groups (OH groups) due to the manufacturing process. These have an impact on the optical transmission of the resulting quartz glass, and they influence the resistance of quartz glass to short-wave UV radiation.

DE 196 49 935 A1 discloses a method for producing an optical component from synthetic transparent quartz glass, wherein a hollow cylindrical soot body is produced as an intermediate product according to the "OVD method" by flame hydrolysis of $SiCl_4$. Due to the manufacturing process the soot body contains a high content of hydroxyl groups. To remove said groups, the porous blank is subjected to a dehydration treatment in a chlorine-containing atmosphere at a high temperature of around 1000°C. In this process OH groups are substituted by chlorine. The soot body treated in this way is subsequently introduced into an evacuable vitrification furnace and vitrified therein with formation of a transparent quartz glass cylinder which is used as a semifinished product for making an optical preform.

As a rule, the synthetic quartz glass produced in this way contains a certain amount of chlorine. It is however known that chlorine (similar to fluorine) may effect a deterioration of the UV radiation resistance of the quartz glass. To be more specific, chlorine leads to a deterioration of the compaction behavior and contributes to induced birefringence under UV laser radiation. The damage pattern known as "compaction" is observed during or after laser irradiation with a high energy density and manifests itself in a local increase in density of the glass in the volume penetrated by radiation, which in turn leads to a locally inhomogeneous rise in the refractive index and thus to a deterioration of the imaging properties of the optical component.

Therefore, measures have been suggested for eliminating chlorine in the porous soot body, for instance in US 2005/0187092, which also discloses an optical component and a method of the above-mentioned type. The publication is concerned with synthetic quartz glass with high UV radiation resistance for lenses, prisms and other optical components for a lithographic device. For the manufacture of quartz glass, use is made of a chlorine-free silicon-containing start compound from which $SiO_2$ particles are produced by flame hydrolysis and deposited on a carrier with formation of an

SiO$_2$ soot body. This soot body is subjected to a dehydration treatment in which the soot body is treated at a temperature of 1050°C in a helium atmosphere with 2.7% chlorine for a period of 4 h. Although the chlorine treatment helps to remove impurities and to reduce the hydroxyl group content, it automatically results in a loading of the soot body with chlorine. Subsequently, the SiO$_2$ soot body is subjected to an intermediate treatment in a helium atmosphere with 3% oxygen and in this process it is slowly heated to a temperature of 1490°C for a period of several hours and sintered into a transparent quartz glass body with a hydroxyl group content of about 10 wtppm. The hydrogen content of the quartz glass is preferably less than 2x10$^{17}$ molecules/cm$^3$.

The intermediate treatment in He/O$_2$ atmosphere serves to remove chlorine from the soot body. H$_2$O and fluorine- or boron-containing substances are mentioned as alternative reactants for the removal of chlorine from synthetic quartz glass.

JP 2000169155 A discloses a method for producing synthetic silica of high heat resistance. A porous soot body is produced which is heated in an ammonia-containing atmosphere for nitriding and further heating the soot body in a hydrogen-containing atmosphere for vitrification. It is mentioned that the content of nitrogen is more than 1.000 wtppm, the content of hydroxyl groups is typically less than 1 wtppm. The content of hydrogen in the silica glass is not mentioned.

JP 2000185924 A discloses a method for producing silica which contains high levels of nitrogen. A porous silica soot body is heated in an atmosphere containing a silicon halide gas, followed by a heat treatment for nitriding the resulting halogen-containing soot body in an ammonia-containing atmosphere, and then vitrifying the nitrided soot body.

Summary of the Invention

It is the object of the present invention to indicate other material measures that are suited for reducing radiation-induced damage to the glass structure. To be more specific, it is the object of the present invention to provide an optical component that is optimized with respect to compaction for use in immersion lithography.

Moreover, it is the object of the present invention to provide a method for producing such an optical component. To be more specific, it is the object of the present invention to provide a method which permits the reproducible and reliable manufacture of synthetic, UV radiation-resistant quartz glass with a predetermined hydroxyl group content and a low chlorine content.

As for the optical component, this object is achieved on the one hand according to the invention by the features that the quartz glass contains chemically bound nitrogen in the range between 1 and 150 wtppm, and the mean hydrogen content of the quartz glass is in the range of 5 x 10$^{15}$ molecules/cm$^3$ to 1 x 10$^{17}$ molecules/cm$^3$. The quartz glass of the optical transparent quartz glass according to the invention contains hydroxyl groups, hydrogen, and nitrogen.

As is generally known, nitrogen increases the viscosity of quartz glass. Surprisingly, it has been found that nitrogen may also accomplish an enhanced radiation resistance of quartz glass. This effect, however, cannot be correlated with the nitrogen content of the quartz glass in a definite way. The total nitrogen content of the quartz glass is rather composed of a portion of physically dissolved nitrogen and a chemically fixedly bound portion, and only the latter is found, either exclusively or at least substantially, to enhance the UV radiation resistance. The nitrogen content within the meaning of this invention is therefore only the nitrogen chemically bound in the glass network. Nitrogen doping does not significantly impair transmission in the ultraviolet wavelength range and in small amounts (within the ppm range) it also shows an acceptable impact on the density and the refractive index of the quartz glass (1 wtppm nitrogen effects a change in density of about 1 ppm). This facilitates the setting of optical properties that are as homogeneous as possible across the volume of the component, also in the case of an incompletely homogeneous distribution of the nitrogen concentration.

Nevertheless, the nitrogen concentration is ideally as constant as possible at least in the used volume of the optical component (also called "CA area" (clear aperture)) because this facilitates the observance of a homogeneous distribution of the fictive temperature.

"Optical component" means here the ready-for-use component of transparent synthetic quartz glass, such as e.g. an enclosed optical lens, but also an intermediate product (blank) which for making the component still requires finishing work, such as machining by drilling, sawing, grinding or polishing. The quartz glass shows minimum absorption, if possible, preferably less than 0.5/cm, for UV radiation of a wavelength of 193 nm.

The synthetic quartz glass is produced with the help of known methods. Examples to be given are flame hydrolysis of SiCl$_4$ or other hydrolysable silicon compounds or the plasma-supported deposition of SiO$_2$ particles. Doping with nitrogen is performed directly during preparation of the synthetic SiO$_2$ particles, during deposition of the SiO$_2$ particles or in a later treatment stage of the quartz glass.

Nitrogen is introduced either via the gas phase and/or in the form of nitrogen-containing chemical compounds that are admixed to a powder to be melted or sintered and release nitrogen during heating.

The impact of nitrogen doping on the refractive index of synthetic quartz glass is described in the technical article "Nitrogen-doped silica fibers and fiber-based optoelectronic components"; K. M. Golant et al; Proceedings of SPIE Vol. 4083 (2000), page 2 - 11".

The impact of nitrogen on the viscosity of quartz glass becomes apparent from "High temperature viscosity of nitrogen modified silica glass"; Koji Tsukuma et al., Journal of Non-Cryst. Solids 265 (2000); 199-209".

The nitrogen content is measured by means of a gas analysis method which is known as "carrier hot gas extraction". An exactly weighed-in sample amount is here heated to a very high degree in a graphite crucible and the nitrogen gas released in this process is detected via the thermal conductivity of the measurement cells. The detection limit of this method is below 1 wtppm for nitrogen.

The mean hydrogen content of the quartz glass is set to a value in the range between $5 \times 10^{15}$ molecules/cm$^3$ and $1 \times 10^{17}$ molecules/cm$^3$. Hydrogen has a healing effect with respect to defects created by UV irradiation in quartz glass. The higher the hydrogen content, the more pronounced is its defect-healing effect in case of UV irradiation. On the other hand, a high hydrogen content may contribute to the formation of SiH groups, which are generally known to have a disadvantageous effect on the compaction behavior. Therefore, the mean hydrogen content of the quartz glass in the quartz glass according to the invention is less than $1 \times 10^{17}$ molecules/cm$^3$. The quartz glass is loaded with hydrogen preferably after vitrification by annealing the quartz glass body at a low temperature (< 500°C) in a hydrogen-containing atmosphere.

The desired effect of nitrogen doping, i.e. the improvement of the UV radiation resistance, depends on the nitrogen content of the quartz glass. The nitrogen content of the quartz glass is within a range between 1 wtppm and 150 wtppm. At nitrogen contents in the ppb range, the positive effect of the nitrogen is not much noticed, and at nitrogen contents above 60 wtppm there is the tendency to form bubbles, which is particularly noticed at more than 150 wtppm. With the simultaneous presence of physically dissolved nitrogen the physical solubility limit for nitrogen in the quartz glass is exceeded earlier and the formation of bubbles already starts at lower nitrogen contents.

In this respect it has turned out to be particularly advantageous when the nitrogen content of the quartz glass is within the range between 10 wtppm and 100 wtppm and is preferably at least 30 wtppm.

As for a high radiation resistance, it has turned out to be particularly advantageous when the quartz glass is doped with nitrogen and boron.

An additional improvement of the UV radiation resistance is accomplished when the quartz glass is doped with oxides or nitrides of trivalent network formers, including Y, Sm or with Zr.

The co-doping of quartz glass with nitrogen and/or boron and one or a plurality of the said rare earth metals leads to a stiffening of the network structure of the quartz glass. The said rare earth metals act as network formers and stiffen the glass structure, and in this respect they can replace nitrogen or boron also in part. These are normally present in the form of oxides. However, particularly with regard to nitrogen doping, which is desired at any rate, the use of nitrides is also advantageous.

Furthermore, it has turned out to be useful when the quartz glass is doped with aluminum.

As is generally known, aluminum shows a stiffening action on the network structure of quartz glass. However, it has been found that the use of a dopant in the form of aluminum in large amounts impairs the optical properties of the quartz glass. Therefore, according to the invention aluminum is only used as a co-dopant in combination with nitrogen and/or boron. It has been found that this aluminum co-doping minimizes the impairment of the optical properties by nitrogen doping and simultaneously improves the UV radiation resistance of the synthetic transparent quartz glass.

In this connection it has turned out to be advantageous when the mean content of aluminum oxide is more than 1.2 wtppm. It has here turned out to be particularly useful when the mean content of aluminum oxide is at least 10 wtppm, preferably at least 20 wtppm. The amounts indicated are based on the content of aluminum in the quartz glass, converted to the molar weight of the oxide $Al_2O_3$.

With regard to a low tendency to compaction of the quartz glass one embodiment of the optical component is preferred in which the quartz glass has a content of hydroxyl groups of less than 40 wtppm, preferably less than 25 wtppm, particularly preferably not more than 15 wtppm.

The higher viscosity of the quartz glass achieved thereby at the same time leads to an improvement of the behavior with respect to a local density change. The lower the content of hydroxyl groups, the lower is the compaction tendency of the quartz glass.

The content of hydroxyl groups follows from a measurement of the IR absorption according to the method of D. M. Dodd et al. "Optical Determinations of OH in Fused Silica", (1966), p. 3911.

Moreover, apart from the lower compaction tendency and the higher viscosity, the low hydroxyl group content may also be important as regards the prevention of an anisotropic density change. It must be assumed that the density change is accompanied by a relocation of hydroxyl groups, said relocation mechanism being all the more probable and easier the more hydroxyl groups are available. Therefore, the low hydroxyl group content and a density of the quartz glass that is as high as possible reduce the sensitivity of the glass structure with respect to a local anisotropic density change.

Since low compaction is accompanied by a high viscosity of the quartz glass, a component is preferred according to the invention in which the viscosity of the quartz glass is at least $10^{13}$ dPa·s at a temperature of 1200°.

The above-explained effects achieved by doping with nitrogen or boron oxide and by a low hydroxyl group content can be offset fully or in part by a high content of halogens. Fluorine and chlorine dopings reduce the density and viscosity of quartz glass, thereby deteriorating the compaction behavior. Therefore, the quartz glass for the optical component according to the invention is preferably without fluorine and its content of chlorine is less than 50 wtppm.

It is assumed that Si-F groups and Si-Cl groups can easily be broken up under UV irradiation in a way similar to Si-OH groups, thereby effecting density changes. The quantitative analysis of chlorine is here carried out in a wet chemical way, with a detection limit of about 50 wtppm.

An absorption band at a wavelength of 163 nm hints at a defect center of the network structure in the form of an oxygen defect, namely an Si-Si group. It has been found that such defects promote compaction of the quartz glass upon UV radiation. Therefore, the quartz glass according to the invention shows absorption of less than 0.5/cm for UV radiation of this wavelength.

The quartz glass component according to the invention withstands compaction by UV radiation better than the known quartz glass qualities, so that it is particularly well suited for an application where UV radiation of a wavelength between 190 nm and 250 nm is transmitted.

As for the method, the above-mentioned object starting from a method of the above-mentioned type is achieved according to the invention in that the soot body is nitrided during or after the dehydration treatment using a nitrogen-containing reaction gas so that the synthetic quartz glass contains chemically bound nitrogen in the range between 1 and 150 wtppm, and that the mean hydrogen content of the quartz glass is set to a value in the range of $5 \times 10^{15}$ molecules/cm$^3$ to $1 \times 10^{17}$ molecules/cm$^3$.

In the method according to the invention the optical component is produced by means of the "soot method". A porous soot body of synthetic $SiO_2$ is here produced as the intermediate product, the hydroxyl group content of said soot body being set to a predetermined value prior to sintering (vitrification; fusion) by means of a dehydration treatment. The soot body is dried at a high temperature in a reactive atmosphere and/or in vacuum.

The development of the prior art according to the invention is based on the measure that the porous soot body is treated in an atmosphere which contains a nitrogen-containing reaction gas. It is the aim to efficiently incorporate chemically dissolved nitrogen into the quartz glass network (here called "nitriding"). This is accomplished by sintering a previously nitrided soot body and/or by sintering in a nitrogen-containing atmosphere. A precondition for the chemical incorporation of nitrogen into quartz glass is an adequately reactive nitrogen source, a sufficiently high nitriding temperature and a sufficiently low density of the soot body. Due to the high temperature one obtains a relatively open reactive glass network into which nitrogen can be chemically incorporated relatively easily. This accomplishes a high amount of chemically dissolved nitrogen in the quartz glass network. This type of nitrogen doping brings about not only an increase in viscosity at high temperatures applied, but also contributes to a lower tendency to compaction, as has been described above with reference to the optical component according to the invention.

The mean hydrogen content of the quartz glass is set to a value in the range between $5 \times 10^{15}$ molecules/cm$^3$ and $1 \times 10^{17}$ molecules/cm$^3$. Hydrogen has a healing effect with respect to defects created by UV irradiation in quartz glass. The higher the hydrogen content, the more pronounced is its defect-healing effect in case of UV irradiation. On the other hand, a high hydrogen content may contribute to the formation of SiH groups, which are generally known to have a disadvantageous effect on the compaction behavior. Therefore, the mean hydrogen content of the quartz glass in the quartz glass according to the invention is less than $1 \times 10^{17}$ molecules/cm$^3$. The quartz glass is loaded with hydrogen preferably after vitrification by annealing the quartz glass body at a low temperature (< 500°C) in a hydrogen-containing atmosphere.

Nitriding is preferably carried out during the dehydration treatment according to method step (b) and/or between the dehydration treatment according to method step (b) and vitrification according to method step (c) and/or during vitrification according to method step (c). According to the invention nitriding results in a synthetic quartz glass contains chemically bound nitrogen in the range between 1 and 150 wtppm.

Reaction gases containing $NH_3$, $ND_3$, $NO_2$ or $N_2O$ have turned out to be a particularly suited nitrogen source.

The substances tend to decompose at a high temperature into reactive nitrogen atoms, contributing to efficient doping. Instead of $NH_3$, the equivalent deuterium-containing compound $ND_3$ can also be used.

Particularly preferred is the use of ammonia ($NH_3$) as the reaction gas, for it has been found that ammonia is also suited for expelling chlorine, which has been introduced into the soot body during the dehydration treatment. Chemically bound chlorine atoms are here obviously replaced by nitrogen atoms. In comparison with hydroxyl groups reactive nitrogen shows an adequate reactivity at high temperatures and is suited to displace hydroxyl groups out of the $SiO_2$ soot body. This variant of the method thereby permits, on the one hand, an efficient drying of the soot body using chlorine and, on the other hand, the removal of chlorine introduced thereby, with simultaneous introduction of chemically bound nitrogen which contributes to the desired nitrogen loading.

The doping treatment using $NH_3$ is preferably carried out at a low nitriding temperature in the range between 800°C and 1250°C.

The reason is that at high temperatures above 1250°C there is also a significant incorporation of hydroxyl and SiH groups due to the decomposition products of ammonia, which in turn may lead to a decrease in the compaction resistance of quartz glass. With respect to this the treatment with NH$_3$ is carried out in a particularly preferred manner at a low nitriding temperature in the range between 800°C and 1250°C, particularly preferably at less than 1200°C.

On the other hand, a doping treatment using NH3 or ND$_3$ may easily lead to hydrogen-containing compound types, such as Si-NH$_2$, which in subsequent hot processes may result in defects. Therefore, a hydrogen-free chemical bond of the nitrogen in the quartz glass network is aimed at. In this respect the nitrogen oxides N$_2$O and/or NO$_2$ are preferably used as the reaction gas.

Dinitrogen monoxide (N$_2$O; laughing gas) also decomposes at a high temperature and releases reactive nitrogen and oxygen in this process. At the same time the reactive oxygen may saturate possible oxygen defects of the glass structure, which has also a favorable impact on the radiation resistance of the quartz glass.

Nitrogen dioxide (NO$_2$) decomposes at high temperatures in the presence of SiO$_2$ with formation of particularly reactive nitrogen atoms which immediately react with SiO$_2$ or with existing defects of the quartz glass network structure and lead to stable Si-N bonds.

The increased partial pressure of the nitrogen-containing reaction gas permits particularly efficient nitrogen doping, especially in the case of simultaneous doping and sintering at a high temperature. This kind of overpressure treatment is here called gas pressure sintering. Due to the high temperature used during gas pressure sintering one obtains a comparatively open reactive glass network into which nitrogen can be incorporated chemically in a relatively easy way. The incorporation of chemically dissolved nitrogen in the quartz glass network is promoted by the increased pressure during gas pressure sintering. This variant of the method has turned out to be particularly useful during use of N$_2$ or N$_2$O as the nitrogen-containing reaction gas.

Preferably, the soot body has a density of not more than 30% of the density of quartz glass - at least before the dehydration treatment.

A density of more than 30% requires a long treatment period for the dehydration treatment of the soot body. A low density of the soot body also facilitates nitrogen doping, particularly good results being here achieved at a relative density of less than 50%, preferably less than 30%. The data regarding relative density are based on a quartz glass density of 2.21 g/cm$^3$.

The optical quartz glass component according to the invention or the optical component produced in the method according to the invention is characterized by low sensitivity to a locally anisotropic and isotropic density change upon irradiation with short-wave UV radiation. Therefore, it is preferably used as the optical component in a projection system or an illumination system of an automatic exposure device for immersion lithography for the purpose of transmitting ultraviolet, pulsed and linearly polarized UV laser radiation of a wavelength between 190 nm and 250 nm.

Preferred Embodiments

The invention will now be explained in the following with reference to embodiments.

Example 1

A soot body is produced by flame hydrolysis of SiCl$_4$ with the help of the known OVD method. The soot body is dehydrated in vacuum at a temperature of 1200°C in a heating furnace comprising a heating element of graphite. Upon completion of the dehydration treatment after 50 hours the hydroxyl group content of the soot body is about 48 wtppm.

The dried soot body is then introduced into a doping furnace and treated therein at a temperature of 1100°C for 20 hours in an atmosphere consisting of 20% by vol. nitrogen, 20% by vol. ammonia, the balance being inert gas. In this process ammonia is decomposed with formation of reactive nitrogen which is able to chemically react with SiO$_2$ under formation of nitrogen bound in the glass network. This is followed by a further treatment of the soot body for 20 hours in an atmosphere consisting of 20% by vol. nitrogen and 80% by vol. inert gas.

Thereafter, the dried and after-treated soot body is vitrified in a sintering furnace at a temperature of about 1750°C in vacuum (10$^{-2}$ mbar) to obtain a transparent quartz glass blank. Said blank is subsequently homogenized by thermally mechanical homogenization (twisting) with formation of a quartz glass cylinder. The mean nitrogen content of the quartz glass is then about 40 wtppm and the hydroxyl group content is about 20 wtppm.

For reducing mechanical stresses and for diminishing birefringence and for producing a compaction resistant glass structure the quartz glass cylinder is subjected to a standard annealing treatment.

The quartz glass cylinder treated in this way has an outer diameter of 350 mm and a thickness of 60 mm. The quartz glass has a mean fictive temperature of 1100°C.

The quartz glass cylinder is then kept in a pure hydrogen atmosphere at 380°C first at an absolute pressure of 2 bar for a period of 300 hours and subsequently at the same temperature at a hydrogen partial pressure of 0 bar for a period of 25 h, and thereafter at an absolute pressure of 0.1 bar for a period of 850 hours.

The resulting quartz glass cylinder is substantially free from chlorine, oxygen defects and SiH groups (below the detection limit of $5 \times 10^{16}$ molecules/cm$^3$), and it is distinguished within a core region having a diameter of 280 mm (CA area) by a mean nitrogen content of 40 wtppm, a mean hydrogen content of $3 \times 10^{16}$ molecules/cm$^3$, a hydroxyl group content of 20 wtppm and a mean fictive temperature of 1100°C. The content of chlorine is below the detection limit. These properties of the quartz glass are summarized in Table 1.

Example 2

A soot body is produced by flame hydrolysis of SiCl$_4$ with the help of the known OVD method, as described with reference to Example 1, but with the following difference with respect to the method of Example 1:

• The soot body is dehydrated at a temperature of 1200°C in a heating furnace having a heating element of graphite by using a chlorine-containing atmosphere. Upon completion of the dehydration treatment after 50 hours the hydroxyl group content of the soot body is about 5 wtppm.

The dried and chlorine-loaded soot body is then introduced into a doping furnace and treated therein at a temperature of 1100°C for 20 hours in an atmosphere consisting of 20% by vol. nitrogen, 20% by vol. ammonia, the balance being inert gas. In this process ammonia is decomposed under formation of reactive nitrogen which is able to expel the chlorine previously introduced in the dehydration treatment. The quartz glass is here simultaneously loaded with chemically bound nitrogen. This is followed by a further treatment of the soot body for 20 hours in an atmosphere consisting of 20% buy vol. nitrogen and 80% by vol. inert gas. The hydroxyl group loading, which is already considerably reduced by chlorine drying, will hardly change in the subsequent treatment steps.
Thereafter, the dried and nitrided soot body is vitrified and further treated, as described by way of Example 1 (annealing, hydrogen loading). Thereafter, the mean nitrogen content of the quartz glass is about 50 wtppm, the hydroxyl group content is about 5 wtppm, the mean hydrogen content about $3 \times 10^{16}$ molecules/cm$^3$, and the mean fictive temperature is 1120°C. Further properties become apparent from Table 1.

Example 3

A quartz glass cylinder is produced, as described above, but with the following differences in comparison with the method of Example 1:

• The soot body is dehydrated in vacuum at a temperature of 1200°C in a heating furnace having a heating element of graphite, the dehydration treatment being only completed after 100 hours. Thereafter, the hydroxyl group content of the soot body is about 30 wtppm. The quartz glass of the soot body contains oxygen defects in the order of $3 \times 10^{16}$ molecules/cm$^3$.
• The dried soot body is subsequently pretreated in a doping and sintering furnace at a temperature of about 1750°C in an atmosphere consisting of 90% by vol. He and 10% by vol. N$_2$O and is subsequently vitrified in the same furnace at 1700°C in a pure He atmosphere to obtain a transparent quartz glass blank.

After the thermally mechanical homogenization (twisting) with formation of a quartz glass cylinder and loading with hydrogen as described in Example 1, the mean nitrogen content of the quartz glass is about 30 wtppm, and the hydroxyl group content is about 30 wtppm. The quartz glass cylinder is substantially free from chlorine, oxygen defects and SiH groups (below the detection limit of $5 \times 10^{16}$ molecules/cm$^3$), and it is distinguished within a diameter of 280 mm (CA area) by a mean hydrogen content of about $3 \times 10^{16}$ molecules/cm$^3$. The mean fictive temperature of the quartz glass is about 1115°C.

Example 4

A soot body doped with aluminum is produced by flame hydrolysis of SiCl$^4$ and aluminum butoxide (C$_{12}$H$_{27}$AlO$_3$). Aluminum butoxide evaporates at about 180°C. A correspondingly highly heated gas stream consisting of the mixture of the two start substances is supplied to a deposition burner, and a soot body is produced by means of this burner in an OVD process in an otherwise standard way, the soot body consisting of synthetic quartz glass doped with about 50 wtppm aluminum oxide.
The soot body doped with aluminum is further treated and sintered, as described with reference to Example 1. This yields a quartz glass cylinder which is substantially free of chlorine, oxygen defects and SiH groups (below the detection limit of $5 \times 10^{16}$ molecules/cm$^3$) and which is distinguished in a core region with a diameter of 280 mm (CA area) by a mean nitrogen content of 40 wtppm, an aluminum oxide content of 50 wtppm, a mean hydrogen content of $3 \times 10^{16}$ molecules/cm$^3$, a hydroxyl group content of 48 wtppm and a mean fictive temperature of 1100°C. The content of chlorine is below the detection limit.

Example 5

A homogeneous mixture of synthetically produced $SiO_2$ powder and $Y_2O_3$ (0.1 wt. % of the total mass) is used as the start material.

The powder mixture is put into a hollow cylindrical graphite mold and vitrified in a sintering furnace by glass pressure sintering. In this process the powder mixture is first slowly heated to 1100°C. During a first phase of nine hours, which comprises heating up and the first three hours of the holding time at this temperature, a vacuum (< 5 mbar) is maintained in the sintering furnace, interrupted by inert-gas flushing operations. During a subsequent second phase a nitrogen overpressure of 12 bar is produced and maintained for six hours before the furnace temperature is raised under vacuum to 1550°C. At this temperature the powder mixture is sintered for a period of 2.5 hours and in vacuum and is then heated up to a temperature of 1700°C and vitrified into a block of transparent quartz glass in this process. First of all, vitrification takes place in vacuum (1 hour) and then in a nitrogen atmosphere at a pressure of 12 bar (2.5 hours).

Subsequent cooling of the quartz glass block to a temperature of 400°C is then carried out at a cooling rate of 2°C/min, the overpressure being further upheld. Free cooling to room temperature is then carried out.

A mean nitrogen concentration of about 50 wtppm and a fictive temperature of 1130°C are thereby set in the quartz glass block. Further properties become apparent from Table 1.

Example 6

A soot body doped with boron is produced by flame hydrolysis of $SiCl_4$ and boron hydride ($B_5H_9$). A gas stream consisting of the mixture of the two start substances is supplied to a deposition burner and a soot body is produced by means of said burner by way of an OVD process in an otherwise standard way, the soot body consisting of synthetic quartz glass doped with about 30 wtppm boron oxide.

The soot body doped with boron is further treated and sintered, as described with reference to Example 3. This yields a quartz glass cylinder in which the mean nitrogen content of the quartz glass, just like the boron oxide content, is about 30 wtppm. The hydroxyl group content is about 25 wtppm. The quartz glass cylinder is substantially free from chlorine, oxygen defects and SiH groups (below the detection limit of $5 \times 10^{16}$ molecules/cm$^3$), and it is distinguished within a diameter of 280 mm (CA area) by a mean hydrogen content of about $3 \times 10^{16}$ molecules/cm$^3$. The mean fictive temperature of the quartz glass is about 1148°C.

Example 7

A homogeneous mixture of synthetically produced $SiO_2$ powder and $ZrO_2$ powder which is mixed with aluminum oxide ($ZrO_2$: 0.1% by wt. of the total mass, $Al_2O_3$: 0.1 wtppm of the total mass) is used as the start material.

The powder mixture is further processed, as described with reference to Example 5. A mean nitrogen concentration of about 50 wtppm and a fictive temperature of 1130°C are set in this process by gas pressure sintering in a nitrogen-containing atmosphere in the quartz glass block. Further properties become apparent from Table 1.

Example 8

A quartz glass cylinder is produced, as described with reference to Example 1, but with the following differences in comparison with that procedure:

• The soot body is dehydrated in vacuum at a temperature of 1200°C in a heating furnace with a heating element of graphite in vacuum, the dehydration treatment being only completed after 100 hours. Thereafter, the hydroxyl group content of the soot body is about 30 wtppm. The quartz glass of the soot body contains oxygen defects in the order of $3 \times 10^{16}$ molecules/cm$^3$.

• The dried soot body is subsequently pretreated in a doping and sintering furnace at a temperature of about 750°C in an atmosphere consisting of 95% by vol. He and 5% by vol. $N_2O$ and is subsequently vitrified at a temperature of about 1750°C in the same furnace in a pure He atmosphere to obtain a transparent quartz glass blank.

After the thermally mechanical homogenization (twisting) with formation of a quartz glass cylinder and loading with hydrogen as described in Example 1, the mean nitrogen content of the quartz glass is about 30 wtppm, and the hydroxyl group content is about 30 wtppm. The quartz glass cylinder is substantially free from chlorine, oxygen defects and SiH groups (below the detection limit of $5 \times 10^{16}$ molecules/cm$^3$), and it is distinguished within a diameter of 280 mm (CA area) by a mean hydrogen content of about $3 \times 10^{16}$ molecules/cm$^3$. The mean fictive temperature of the quartz glass is about 1115°C.

**Table 1**

| Properties | Example | | | | | | | | |
|---|---|---|---|---|---|---|---|---|---|
| | 1 | 2 | 3 | 4 | 5 | 6 | 7 | 8 | R |
| N$_2$ [wtppm] | 40 | 50 | 30 | 40 | 50 | 30 | 50 | 30 | 0 |
| B$_2$O$_3$ [wtppm] | 0 | 0 | 0 | 0 | 0 | 30 | 0 | 0 | 0 |
| OH [wtppm] | 20 | 5 | 30 | 48 | 20 | 25 | 10 | 30 | 250 |
| H$_2$ [cm$^{-3}$] | 3 E16 | 3 E16 | 3 E16 | 3 E16 | < 2 E15 | 3 E16 | 3 E16 | 3 E16 | 1.4 E16 |
| Chlorine [wtppm] | n.d. | n.d. | n.d. | n.d. | n.d. | n.d. | n.d. | n.d. | n.d. |
| Y$_2$O$_3$ [% by wt.] | 0 | 0 | 0 | 0 | 0.1 | 0 | 0 | 0 | 0 |
| Zr0$_2$ % by wt.] | 0 | 0 | 0 | 0 | 0 | 0 | 0.1 | 0 | 0 |
| Al$_2$O$_3$ [wtppm] | 0 | 0 | 0 | 50 | 0 | 0 | 0.1 | 0 | 0 |
| Lg viscosity [d Pas] | 13.3 | 13.4 | 13.0 | 13.6 | 13.6 | 13.4 | 13.5 | 13.0 | 12.0 |
| Tf [°C] | 1100 | 1120 | 1115 | 1100 | 1130 | 1148 | 1130 | 1115 | 1040 |
| **M [rel. to R]** | **0.15** | **1.13** | **0.2** | **0.1** | **0.18** | **0.17** | **0.18** | **0.2** | **1** |
| n.d.: below the detection limit, R: reference sample, Lg viscosity: the data refer to a temperature of 1200 °C, Tf: fictive temperature, M: measured value for the compaction behavior of the glass, relative to reference sample R | | | | | | | | | |

All data indicated in Table 1 are mean values. The compaction behavior of the respective quartz glass qualities was determined as follows:

Rod-shaped samples of the corresponding quartz glass were produced with a dimension of 25 x 25 x 100 m$^3$ and prepared each time in the same way (polish of the opposite 25 x 25 mm$^2$ areas). The samples were irradiated with UV radiation having a wavelength of 193 nm, the pulse energy density being 0.1 mJ/cm$^2$ and the pulse number 5 billions each time.

After the irradiation tests the compaction was determined in that the relative increase or decrease in the reactive index in the irradiated area as compared with the nonirradiated area was measured with a commercially available interferometer (Zygo GPI-XP) at a wavelength of 633 nm.

The compaction behavior of all of the quartz glass samples 1 to 8 is compared with that of a reference sample, the manufacture of which is described in EP 1 327 612 A1 and which is designated there as Sample 2a. The manufacture of the reference sample shall briefly be explained in the following:

A tubular soot body is produced and subjected to a dehydration treatment for removing the hydroxyl groups introduced due to the manufacturing process, in which dehydration treatment the soot body is treated in a vacuum chamber for a treatment period of about eight hours at a temperature around 900°C. The mean hydroxyl group concentration is about 250 wtppm after said treatment. Subsequently, the soot body is sintered zone by zone in a vacuum vitrification furnace at a temperature in the range around 1400°C. The hydrogen-containing atmosphere inside the vitrification furnace is maintained with a hydrogen partial pressure of 10 mbar. Thereafter the sintered (vitrified) quartz glass tube exhibits an averaged hydrogen concentration of about $4 \times 10^{16}$ molecules/cm$^3$ across its wall thickness. The hydroxyl group content is 250 wtppm. Further properties of the reference sample R are shown in the last column of Table 1.

The specific measured value M for the compaction behavior is as follows. The compaction curve in time can be arithmetically shown as

$$prefactor \; x \; (dose)^{0.6},$$

where the dose is the quotient of (energy density$^2$ x pulse number) and the pulse width in time. The compaction curve in time (curve shape) is similar for all samples, but on a different scale defined by the prefactor. The prefactor is thus glass-specific, and it characterizes the compaction behavior of the quartz glass in question. The specific prefactor of glass samples 1 to 8 is standardized with respect to that of the reference sample, resulting in a relative factor M which corresponds to the measured value for the glass compaction.

The measured value determined in this way for the compaction behavior of the respective quartz glass samples is indicated in the last line of Table 1. The smaller the measured value, the lower is the compaction of the respective quartz glass upon irradiation with high-energy UV radiation.

**Claims**

1. An optical component of synthetic quartz glass for use in immersion lithography at an operating wavelength below 250 nm, **characterized in that** the quartz glass contains hydroxyl groups in the range of from 1 wtppm to 60 wtppm and chemically bound nitrogen in the range between 1 and 150 wtppm, and that the mean hydrogen content of the quartz glass is in the range of $5 \times 10^{15}$ molecules/cm$^3$ to $1 \times 10^{17}$ molecules/cm$^3$.

2. The component according to claim 1, **characterized in that** the nitrogen content of the quartz glass is in the range between 10 and 100 wtppm, particularly preferably at least 30 wtppm.

3. The component according to claim 1 or claim 2, **characterized in that** the quartz glass is doped with nitrogen and with boron.

4. The component according to any one of the preceding claims, **characterized in that** the quartz glass is doped with oxides or nitrides of trivalent network formers, including Y, Sm or with Zr.

5. The component according to any one of the preceding claims, **characterized in that** the quartz glass is doped with aluminum, whereby the mean content of aluminum oxide is more than 1.2 wt ppm.

6. The component according to claim 5, **characterized in that** the mean content of aluminum oxide is at least 10 wtppm, preferably at least 20 wtppm.

7. The component according to any one of the preceding claims, **characterized in that** the quartz glass has a content of hydroxyl groups of less than 40 wtppm, preferably less than 25 wtppm, particularly preferably not more than 15 wtppm.

8. The component according to any one of the preceding claims, **characterized in that** the viscosity of the quartz glass is at least $10^{13}$ dPa·s at a temperature of 1200°C.

9. The component according to any one of the preceding claims, **characterized in that** the quartz glass has a content of chlorine of less than 50 wtppm.

10. The component according to any one of the preceding claims, **characterized in that** the quartz glass shows absorption of less than 0.5/cm for UV radiation of a wavelength of 163 nm.

11. A method for producing synthetic quartz glass with a predetermined hydroxyl group content, comprising the following method steps:

    (a) a porous SiO$_2$ soot body is produced by flame hydrolysis or oxidation of a silicon-containing start compound and by layerwise deposition of SiO$_2$ particles on a carrier,
    (b) the soot body is subjected to a dehydration treatment in a drying atmosphere for removing hydroxyl groups, so that a mean hydroxyl group content of less than 60 wt ppm is set,
    (c) the SiO$_2$ soot body is vitrified to obtain a body made from the synthetic quartz glass, and
    (d) the mean hydrogen content of the quartz glass is set to a value in the range of less than $2 \times 10^{17}$ molecules/cm$^3$,

**characterized in that** the soot body is nitrided during or after the dehydration treatment using a nitrogen-containing reaction gas, so that the synthetic quartz glass contains chemically bound nitrogen in the range between 1 and 150 wtppm and that the mean hydrogen content of the quartz glass is set to a value in the range of $5 \times 10^{15}$ molecules/cm$^3$ to $1 \times 10^{17}$ molecules/cm$^3$.

12. The method according to claim 11, **characterized in that** nitriding is carried out during the dehydration treatment according to method step (b).

13. The method according to claim 11 or 12, **characterized in that** nitriding is carried out between the dehydration treatment according to method step (b) and vitrification according to method step (c).

14. The method according to any one of the preceding method claims, **characterized in that** nitriding is carried out during vitrification according to method step (c).

15. The method according to any one of the preceding method claims, **characterized in that** $NH_3$, $ND_3$, $NO_2$ or $N_2O$ is used as the nitrogen-containing reaction gas.

16. The method according to claim 15, **characterized in that** the doping treatment is carried out using $NH_3$ (or $ND_3$) at a low nitriding temperature in the range between 800°C and 1250°C, preferably below 1200°C.

17. The method according to any one of the preceding method claims, **characterized in that** the soot body shows a density of not more than 30% of the density of quartz glass at least at the beginning of the dehydration treatment.

**Patentansprüche**

1. Optisches Bauteil aus synthetischem Quarzglas zur Verwendung bei der Immersionslithographie bei einer Arbeitswellenlänge unterhalb von 250 nm, **dadurch gekennzeichnet, dass** das Quarzglas Hydroxylgruppen im Bereich von 1 Gew.-ppm bis 60 Gew.-ppm und chemisch gebundenen Stickstoff im Bereich zwischen 1 und 150 Gew.-ppm enthält, und dass der mittlere Wasserstoffgehalt des Quarzglases im Bereich von $5 \times 10^{15}$ Molekülen/cm$^3$ bis $1 \times 10^{17}$ Molekülen/cm$^3$ liegt.

2. Bauteil nach Anspruch 1, **dadurch gekennzeichnet, dass** der Stickstoffgehalt des Quarzglases im Bereich zwischen 10 und 100 Gew.-ppm liegt, vorzugsweise mindestens 30 Gew.-ppm beträgt.

3. Optisches Bauteil nach Anspruch 1 oder 2, **dadurch gekennzeichnet, dass** das Quarzglas mit Stickstoff und mit Bor dotiert.

4. Bauteil nach einem der vorhergehenden Ansprüche, **dadurch gekennzeichnet, dass** das Quarzglas mit Oxiden oder Nitriden dreiwertiger Netzwerkbildner, umfassend Y, Sm, oder mit Zr dotiert ist.

5. Bauteil nach einem der vorhergehenden Ansprüche, **dadurch gekennzeichnet, dass**, **dadurch gekennzeichnet, dass** das Quarzglas mit Aluminium dotiert ist, wobei der mittlere Gehalt an Aluminiumoxid mehr als 1,2 Gew.-ppm beträgt.

6. Bauteil nach Anspruch 5, **dadurch gekennzeichnet, dass** der mittlere Gehalt an Aluminiumoxid mindestens 10 Gew.-ppm, vorzugsweise mindestens 20 Gew.-ppm, beträgt.

7. Bauteil nach einem der vorhergehenden Ansprüche, **dadurch gekennzeichnet, dass** das Quarzglas einen Gehalt an Hydroxylgruppen von weniger als 40 Gew.-ppm, vorzugsweise weniger als 25 Gew.-ppm, besonders bevorzugt maximal 15 Gew.-ppm, aufweist.

8. Bauteil nach einem der vorhergehenden Ansprüche, **dadurch gekennzeichnet, dass** die Viskosität des Quarzglases bei einer Temperatur von 1200°C mindestens $10^{13}$ dPa.s beträgt.

9. Bauteil nach einem der vorhergehenden Ansprüche, **dadurch gekennzeichnet, dass** das Quarzglas einen Gehalt an Chlor von weniger als 50 Gew.-ppm aufweist.

10. Bauteil nach einem der vorhergehenden Ansprüche, **dadurch gekennzeichnet, dass** das Quarzglas für UV-Strahlung einer Wellenlänge von 163 nm eine Absorption von weniger als 0,5/cm aufweist.

11. Verfahren zur Herstellung von synthetischem Quarzglas mit vorgegebenem Hydroxylgruppengehalt, umfassend die folgenden Verfahrensschritte

(a) durch Flammenhydrolyse oder Oxidation einer siliziumhaltigen Ausgangsverbindung und schichtweises Abscheiden von $SiO_2$-Partikeln auf einem Träger wird ein poröser $SiO_2$-Sootkörper hergestellt,

(b) der Sootkörper wird zum Entfernen von Hydroxylgruppen einer Dehydratationsbehandlung in einer Trocknungsatmosphäre unterzogen, so dass sich ein mittlerer Hydroxylgruppengehalt von weniger als 60 Gew.-ppm einstellt,

(c) der $SiO_2$-Sootkörper wird zu einem Körper aus dem synthetischen Quarzglas verglast, und

(d) der mittlere Wasserstoffgehalt des Quarzglases wird auf einen Wert im Bereich von weniger als $2 \times 10^{17}$ Molekülen/cm$^3$ eingestellt,

**dadurch gekennzeichnet, dass** der Sootkörper während oder nach der Dehydratationsbehandlung unter Einsatz eines Stickstoff enthaltenden Reaktionsgases nitridiert wird, derart, dass das synthetische Quarzglas chemisch gebundenen Stickstoff im Bereich zwischen 1 und 150 Gew.-ppm enthält, und dass der mittlere Wasserstoffgehalt des Quarzglases auf einen Wert im Bereich von $5 \times 10^{15}$ Molekülen/cm$^3$ bis $1 \times 10^{17}$ Molekülen/cm$^3$ eingestellt wird.

12. Verfahren nach Anspruch 11, **dadurch gekennzeichnet, dass** die Nitridierung während der Dehydratationsbehandlung gemäß Verfahrensschritt (b) durchgeführt wird.

13. Verfahren nach Anspruch 11 oder 12, **dadurch gekennzeichnet, dass** die Nitridierung zwischen der Dehydratationsbehandlung gemäß Verfahrensschritt (b) und dem Verglasen gemäß Verfahrensschritt (c) durchgeführt wird.

14. Verfahren nach einem der vorhergehenden Verfahrensansprüche, **dadurch gekennzeichnet, dass** die Nitridierung während des Verglasens gemäß Verfahrensschritt (c) durchgeführt wird.

15. Verfahren nach einem der vorhergehenden Verfahrensansprüche, **dadurch gekennzeichnet, dass** als Stickstoff enthaltendes Reaktionsgas $NH_3$, $ND_3$, $NO_2$ oder $N_2O$ eingesetzt wird.

16. Verfahren nach Anspruch 15, **dadurch gekennzeichnet, dass** die Dotierbehandlung unter Einsatz von $NH_3$ (oder $ND_3$) bei einer niedrigen Nitridierungstemperatur im Bereich zwischen 800 und 1250 °C, vorzugsweise unterhalb von 1200 °C erfolgt.

17. Verfahren nach einem der vorhergehenden Verfahrensansprüche, **dadurch gekennzeichnet, dass** der Sootkörper zumindest zu Beginn der Dehydratationsbehandlung eine Dichte von maximal 30 % der Dichte von Quarzglas aufweist.

**Revendications**

1. Composant optique de verre de quartz synthétique pour une utilisation en lithographie en immersion à une longueur d'ondes de service inférieure à 250 nm **caractérisé en ce que** le verre de quartz contient des groupes hydroxyles compris entre 1 ppm en poids et 60 ppm en poids et de l'azote lié chimiquement entre 1 et 150 ppm en poids et **en ce que** la teneur moyenne en hydrogène de verre de quartz est comprise entre $5 \times 10^{15}$ molécules/cm$^3$ et $1 \times 10^{17}$ molécules/cm$^3$.

2. Composant selon la revendication 1, **caractérisé en ce que** la teneur en azote du verre de quartz est comprise entre 10 et 100 ppm en poids en particulier de préférence au moins 30 ppm en poids.

3. Composant selon l'une des revendications 1 ou 2, **caractérisé en ce que** le verre de quartz est dopé à l'azote et au bore.

4. Composant selon l'une des revendications précédentes, **caractérisé en ce que** le verre de quartz est dopé aux oxydes ou nitrures de formateurs de réseau trivalent comprenant Y, Sm ou Zr.

**5.** Composant selon l'une des revendications précédentes **caractérisé en ce que** le verre de quartz est dopé en aluminium, la teneur moyenne d'oxyde d'aluminium est au moins de 1,2 ppm en poids.

**6.** Composant selon la revendication 1, **caractérisé en ce que** la teneur moyenne en oxyde d'aluminium est au moins de 10 ppm en poids, de préférence au moins de 20 ppm en poids.

**7.** Composant selon l'une des revendications précédentes **caractérisé en ce que** le verre de quartz présente une teneur en groupes hydroxyles inférieure à 40 ppm en poids, de préférence inférieure à 25 ppm en poids, particulièrement de préférence pas plus de 15 ppm en poids.

**8.** Composant selon l'une des revendications précédentes **caractérisé en ce que** la viscosité du verre de quartz est au moins de $10^{13}$ dPa à une température de 200°C.

**9.** Composant selon l'une des revendications précédentes **caractérisé en ce que** le verre de quartz présente une teneur en chlore inférieure à 50 ppm en poids.

**10.** Composant selon l'une des revendications précédentes **caractérisé en ce que** le verre de quartz fait preuve d'une absorption inférieure à 0,5/cm pour un rayonnement UV de longueur d'onde de 163 nm.

**11.** Procédé pour produire un verre de quartz synthétique avec une teneur en groupe hydroxyle prédéterminé, comprenant les étapes de procédé suivantes:

(a) un corps de suie poreux $SiO_2$ est produit par hydrolyse à la flamme ou oxydation d'un composé initial contenant de la silice et par déposition de couches de particules de $SiO_2$ sur un substrat,
(b) le corps de suie est soumis à un traitement de déshydratation dans une atmosphère de séchage pour retrait des groupes hydroxyles de sorte qu'une teneur moyenne de groupe hydroxyle inférieure à 60 ppm en poids est établie,
(c) le corps de suie $SiO_2$ est vitrifié pour obtenir un corps fait de verre de quartz synthétique et
(d) la teneur moyenne en hydrogène du verre de quartz est établie à une valeur inférieure à $2 \times 10^{17}$ molécules/cm$^3$,

**caractérisé en ce que** le corps de suie est nitruré pendant ou après le traitement de déshydratation utilisant un gaz de réaction contenant de l'azote de sorte que le verre de quartz synthétique contenant de l'azote lié chimiquement entre 1 et 150 ppm en poids et **en ce que** la teneur moyenne en hydrogène est établie à une valeur comprise entre $5 \times 10^{15}$ molécules/cm$^3$ et $1 \times 10^{17}$ molécules/cm$^3$.

**12.** Procédé selon la revendication 11, **caractérisé en ce que** la nitruration est effectuée pendant le traitement de déshydratation selon l'étape de procédé (b).

**13.** Procédé selon la revendication 11 ou 12, **caractérisé en ce que** la nitruration est effectuée entre le traitement de déshydratation selon l'étape de procédé (b) et la vitrification selon l'étape de procédé (c).

**14.** Procédé selon l'une des revendications précédentes **caractérisé en ce que** la nitruration est effectuée pendant la vitrification selon l'étape de procédé (c).

**15.** Procédé selon l'une des revendications précédentes **caractérisé en ce que** $NH_3$, $ND_3$, $NO_2$ ou $N_2O$ est utilisé comme gaz de réaction contenant de l'azote.

**16.** Procédé selon l'une des revendications précédentes **caractérisé en ce que** le traitement de dopage est effectué en utilisant $NH_3$ (ou $ND_3$) à une température de nitrification basse comprise entre 800°C et 1250°C, de préférence inférieure à 1200°C.

**17.** Procédé selon l'une des revendications précédentes **caractérisé en ce que** le corps de suie montre une densité inférieure ou égale à 30 % de la densité de verre de quartz au moins au début du traitement de déshydratation.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1712528 A2
- EP 1586544 A1
- DE 19649935 A1
- US 20050187092 A
- JP 2000169155 A
- JP 2000185924 A
- EP 1327612 A1

**Non-patent literature cited in the description**

- **K. M. GOLANT et al.** Nitrogen-doped silica fibers and fiber-based optoelectronic components. *Proceedings of SPIE,* 2000, vol. 4083, 2-11
- **KOJI TSUKUMA et al.** High temperature viscosity of nitrogen modified silica glass. *Journal of Non-Cryst. Solids,* 2000, vol. 265, 199-209
- **D. M. DODD et al.** *Optical Determinations of OH in Fused Silica,* 1966, 3911